# EUROPEAN PATENT SPECIFICATION

(11) **EP 3 021 036 B1**
(45) Date of publication and mention of the grant of the patent: **06.01.2021**
(21) Application number: 15193530.1
(22) Date of filing: 06.11.2015
(51) Int. Cl.: F21V 8/00, G02B 6/00, G02F 1/13357, H01L 25/075, H01L 33/60, H01L 33/62, H01L 33/64

(54) **PLANAR LIGHT SOURCE AND METHOD FOR MANUFACTURING THE SAME**
PLANARE LICHTQUELLE UND METHODE ZUR HERSTELLUNG DERSELBEN
SOURCE DE LUMIÈRE PLANAIRE ET PROCÉDÉ DE FABRICATION DE CELLE-CI

(30) Priority: 11.11.2014 TW 103138981
(43) Date of publication of application: 18.05.2016
(73) Proprietor: Kuo, Chin-Piao, Hsin Chu County (TW); Tsai, Pei-Jie, Hsin Chu County (TW)
(72) Inventor: Kuo, Chin-Piao, Hsin Chu County (TW); Tsai, Pei-Jie, Hsin Chu County (TW)
(74) Representative: Lang, Christian

(56) References cited:
- DE-A1- 10 025 449
- KR-A- 20120 137 075
- US-A1- 2007 008 739
- US-A1- 2014 218 954
- US-A1- 2014 347 880

## Description

### BACKGROUND OF THE INVENTION

### Field of the Invention

The invention relates to a planar light source and a method for manufacturing the same, and more particularly to a planar light source comprising a light-emitting diode (LED) light bar, which can simplify the manufacturing processes and improve the light-emitting efficiency, and a method for manufacturing the same.

### Related Art

A light-emitting diode (LED) has the characteristics including a high response speed, a small size, a low power-consumption, less heat and a long lifetime, and thus has gradually replaced the conventional illumination lamp, such as the incandescent light bulb, the halogen lamp or the like.

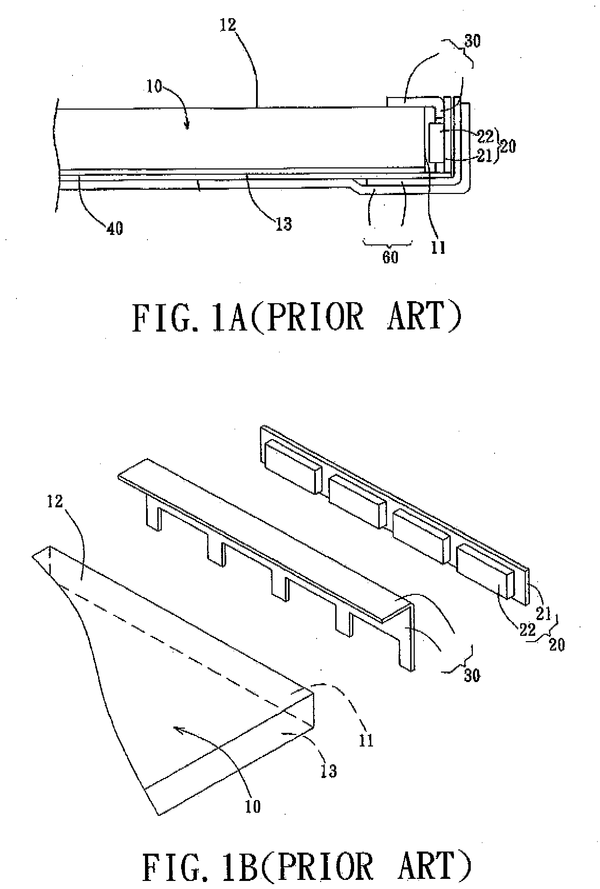

FIG. 1A is a schematic view showing a conventional backlight structure. FIG. 1B is an exploded view showing the backlight structure of FIG. 1A. Referring to FIGS. 1A and 1B, the backlight structure comprises a light guide plate 10, a light-emitting module 20, a reflective shell 30, a reflector 40 and a support structure 60. The light guide plate 10 has a light input side 11, a light-emitting surface 12 and a bottom surface 13. The light-emitting surface 12 is a surface of the light guide plate 10 facing upwards, and the bottom surface 13 is the other opposite surface of the light guide plate 10 facing downwards. The light input side 11 is disposed on a sidewall of the light guide plate 10. The light-emitting surface 12 and the bottom surface 13 are formed on two opposite end edges of the light input side 11, respectively, so that an angle is formed between the light input side 11 and each of the light-emitting surface 12 and the bottom surface 13 abutting upon the light input side 11.

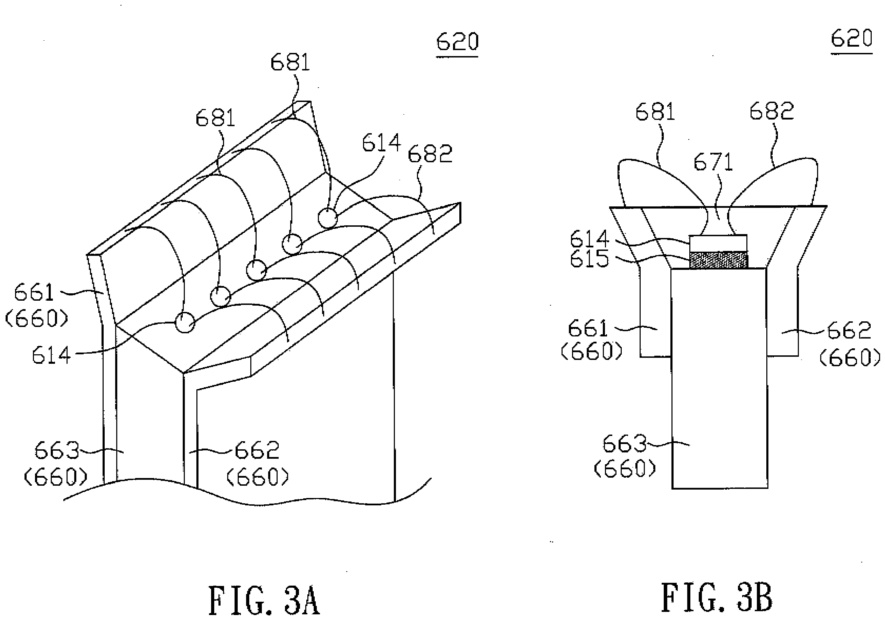

The light-emitting module 20 comprises a substrate 21 and a LED device 22, which is disposed on the substrate 21 and emits light toward the light input side 11. In the light-emitting module 20, LEDs are adopted to form a light bar of the LED device 22. In another example, when the bottom surface 13 is formed with an optical micro-structure, the portion of the bottom surface 13 opposite to the LED device 22 may be reserved without the optical micro-structure (see FIG. 3) to prevent the formation of the hot spot, so that the optical energy availability is enhanced. The detailed contents may be found in the disclosure of TW 201211644 A1 (Taiwan Patent Application Serial No. 100121649).

Regarding the package method for the existing LED device, the dispensing, auto encapsulating or molding is directly performed after die bonding and wire bonding. The conventional die bonding method is to utilize a silver paste or a transparent insulation paste to adhere the die (chip) into the package unit, so that the overall LED device is disposed on a substrate. The heat generated by the LED device is transferred from the inside of the component of the LED device to the component substrate by way of conducting, and then transferred to the substrate or the heat sink of the package unit through the silver paste or the transparent insulation paste.

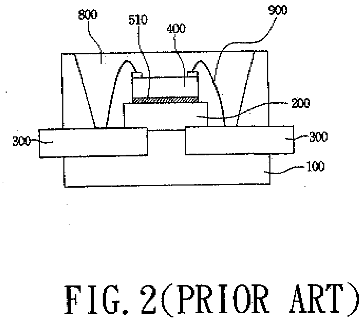

FIG. 2 is a schematic view showing an example of a conventional LED device. Referring to FIG. 2, the LED device comprises a base 100, a substrate 200, a frame 300, a LED chip 400, a first mixed colloid 510 and a package material 800. The substrate 200 and the frame 300 are disposed on the base 100, and the first mixed colloid 510 is coated between the substrate 200 and the LED chip 400 to adhere the LED chip 400 to the substrate 200. The LED chip 400 is connected to the frame 300 through wires 900 to provide the electric power to the LED chip 400 to emit light in a face-up manner. The package material 800 is poured into the base 100 to cover the substrate 200, the LED chip 400 and the wires 900. The first mixed colloid 510 is disposed between the substrate 200 and the LED chip 400, provides the adhesive property to adhere the LED chip 400 onto the substrate 200, and further provides the heat conductivity property to transfer the heat, generated by the LED chip 400 upon light emitting, to the base 100 through the substrate 200 so that the heat dissipating is performed. The detailed contents may be found in the disclosure of TW 200905913 A1 (Taiwan Patent Application Serial No. 096127147). Further conventional LED devices may be found in other disclosures. According to the US patent application with No.

US 2014/218954 A1, a light-emitting device package module is disclosed which includes a light-emitting device, a first circuit board and a second circuit board. The light-emitting device is mounted on and electrically connected to the first circuit board. The second circuit board may be assembled with the first circuit board by using a connection member having various shapes and is electrically connected to the first circuit board. According to the Korean patent application with No. KR 2012 0137075 A, an LED module is provided which comprises a light emitting device and a printed circuit board. The printed circuit board comprises a first area and a second area. The first area comprises an electrode layer which is electrically connected to the light emitting device. The second area forms an inclination angle with the first area and reflects light which is generated in the light emitting device. According to the German patent application with No. DE 100 25 449 A1, a fastening strip for SMD LEDs is provided in which a mechanical coupling is carried out by an insulating link element. Each fastening element contains interlocking elements for engaging SMD components, such that SMD components can be retained between two fastening elements. The fastening elements are electrically conductive, at least in sections, such that contact faces are formed. According to the US patent application with No. US 2007/008739 A1 an edge-illuminated planar light source is provided, wherein a metallic LED light bar is partially embedded in a transparent light guide plate.

The glue material or resin (i.e., the package material 800) typically used in packaging has the refractive index equal to 1.5, while the air has the refractive index equal to 1. Because the dies (chips), the components (devices) and the package material have the refractive indexes significantly different from the refractive index of the light guide plate 10, the light-emitting efficiency of the packaged LED device is decreased due to the too-small angle of total reflection. In addition, in the backlight module, the light rays of the dies (chips) penetrate through the package material 800, then enter the air, and are then incident into the light guide plate 10. Because the light rays must penetrate through the interfaces of different media several times, the optical loss is high.

### SUMMARY OF THE INVENTION

According to the invention, a planar light source comprising a light guide plate and a LED light bar is provided. The LED light bar comprises a light bar substrate, at least one bonding layer, at least one LED chip, at least one first wire, at least one second wire and at least one package unit. The light bar substrate comprises an intermediate metal plate, a first side metal plate, and a second side metal plate, and defines a receiving space. The first side metal plate is insulatingly attached to a first side surface of the intermediate metal plate, and the second side metal plate is insulatingly attached to a second side surface of the intermediate metal plate. The intermediate metal plate comprises a light-emitting surface. Each LED chip is bonded to the light-emitting surface of the intermediate metal plate by a bonding layer. Each first wire is coupled between a positive terminal of a LED chip and the first side metal plate and serves as an electroconductive path for the positive terminal of the LED chip. Each second wire is coupled between a negative terminal of a LED chip and the second side metal plate and serves as an electroconductive path for the negative terminal of the LED chip. Each package unit comprises fluorescent powders and a package material and packages a LED chip. The light guide plate is composed of a light-guiding material. The LED light bar is disposed on a lateral side of the light guide plate. At least a portion of the receiving space of the LED light bar is embedded in the lateral side of the light guide plate. The light guide plate directly contacts the at least one package unit.

In one embodiment, the light-emitting surface of the intermediate metal plate is longitudinally narrow and disposed between the first side surface and the second side surface of the intermediate metal plate. Each of the first side metal plate and the second side metal plate comprises a salient The salients project beyond the light-emitting surface of the intermediate metal plate, and are bent outwardly by a predetermined angle in directions away from the first side surface and the second side surface of the intermediate metal plate, respectively, so that the light-emitting surface of the intermediate metal plate and inner surfaces of the salients of the first side metal plate and the second side metal plate commonly define the receiving space.

In one embodiment, a light reflecting layer is formed on each of the light-emitting surface of the intermediate metal plate and the inner surfaces of the salients of the first side metal plate and the second side metal plate defining the receiving space.

In one embodiment, the first side metal plate comprises separated or insulated first side metal sub-plates for controlling different groups of LED chips.

In one embodiment, the second side metal plate comprises separated or insulated second side metal sub-plates for connecting the different groups of LED chips in series or in parallel.

In one embodiment, each package unit is partially filled into the receiving space, and the light-guiding material of the light guide plate is filled into the receiving space and directly contacts each package unit.

According to the invention, a method for manufacturing a planar light source is provided. The method comprises the following steps. A light bar substrate is provided. The light bar substrate defines a receiving space and comprises an intermediate metal plate, a first side metal plate, and a second side metal plate. The first side metal plate is insulatingly attached to a first side surface of the intermediate metal plate. The second side metal plate is insulatingly attached to a second side surface of the intermediate metal plate. At least one bonding layer is utilized to bond at least one LED chip to a light-emitting surface of the intermediate metal plate. Positive and negative terminals of the at least one LED chip are coupled to the first side metal plate and the second side metal plate via at least one first wire and at least one second wire by way of wire bonding, respectively. At least one package unit, comprising fluorescent powders and a package material, is coated into the receiving space to package the at least one LED chip and to form a LED light bar. The receiving space of the LED light bar is placed into a mold, and a light-guiding material is poured into the mold, and then the light-guiding material polymerizes into a light guide plate in the mold by way of heat treatment to form the planar light source having the LED light bar and the light guide plate integrally formed together.

In one embodiment, the light-emitting surface of the intermediate metal plate is longitudinally narrow and disposed between the first side surface and the second side surface of the intermediate metal plate. Each of the first side metal plate and the second side metal plate comprises a salient. The salients project beyond the light-emitting surface of the intermediate metal plate, and are bent outwardly by a predetermined angle in directions away from the first side surface and the second side surface of the intermediate metal plate, respectively, so that the light-emitting surface of the intermediate metal plate and inner surfaces of the salients of the first side metal plate and the second side metal plate commonly define the receiving space.

In one embodiment, a light reflecting layer is formed on each of the light-emitting surface of the intermediate metal plate and the inner surfaces of the salients of the first side metal plate and the second side metal plate defining the receiving space.

In one embodiment, the first side metal plate comprises separated or insulated first side metal sub-plates for controlling different groups of LED chips.

In summary, the invention provides a planar light source using a LED light bar and a method for manufacturing the same, wherein the LED light bar is placed in a mold in advance in the manufacturing process, so that the planar light source with the LED light bar and a light guide plate integrally formed together can be obtained, and most of the light rays can enter the light guide plate to significantly increase the efficiency of the planar light source. In addition, each LED chip of the invention is directly mounted onto a light bar substrate without using the conventionally used lead frame. So, no thermal resistance of the lead frame is present, and the heat generated by a LED chip can be rapidly conducted and dissipated through the intermediate metal plate of the light bar substrate of the invention. Therefore, the operation temperature of the LED chip can be effectively decreased, and the light-emitting efficiency and lifetime can be thus increased.

### BRIEF DESCRIPTION OF THE DRAWINGS

FIG. 1A is a schematic view showing a conventional backlight structure.
FIG. 1B is an exploded view showing the backlight structure of FIG. 1A
FIG. 2 is a schematic view showing an example of a conventional LED device.
FIG. 3A is a pictorial view showing a LED light bar as used in a planar light source according to an embodiment of the invention.
FIG. 3B is a cross-sectional view showing the LED light bar of FIG. 3A.
FIG. 4A is a side view showing a planar light source according to an embodiment of the invention.
FIG. 4B is a top view showing the planar light source of FIG. 4A.
FIG. 5 is a pictorial view showing a LED light bar as used in a planar light source according to another embodiment of the invention.
FIG. 6 is a flow chart showing a method for manufacturing a planar light source according to an embodiment of the invention.

### DETAILED DESCRIPTION OF THE INVENTION

FIG. 3A is a pictorial view showing a LED light bar as used in a planar light source according to an embodiment of the invention. FIG. 3B is a cross-sectional view showing the LED light bar of FIG. 3A. Referring to FIGS. 3A and 3B, a LED light bar 620 comprises a light bar substrate 660, at least one LED chip 614, at least one bonding layer 615, at least one first wire 681, at least one second wire 682, and at least one package unit 671. The light bar substrate 660 comprises an intermediate metal plate 663, a first side metal plate 661, and a second side metal plate 662.

Each of the intermediate metal plate 663, the first side metal plate 661, and the second side metal plate 662 is a cuboid. The intermediate metal plate 663 is thicker and wider, and may be made of aluminum coated with silver or copper coated with silver to rapidly conduct the heat generated by each LED chip 614. The first side metal plate 661 is insulatingly attached to a first side surface of the intermediate metal plate 663. The second side metal plate 662 is insulatingly attached to a second side surface of the intermediate metal plate 663.

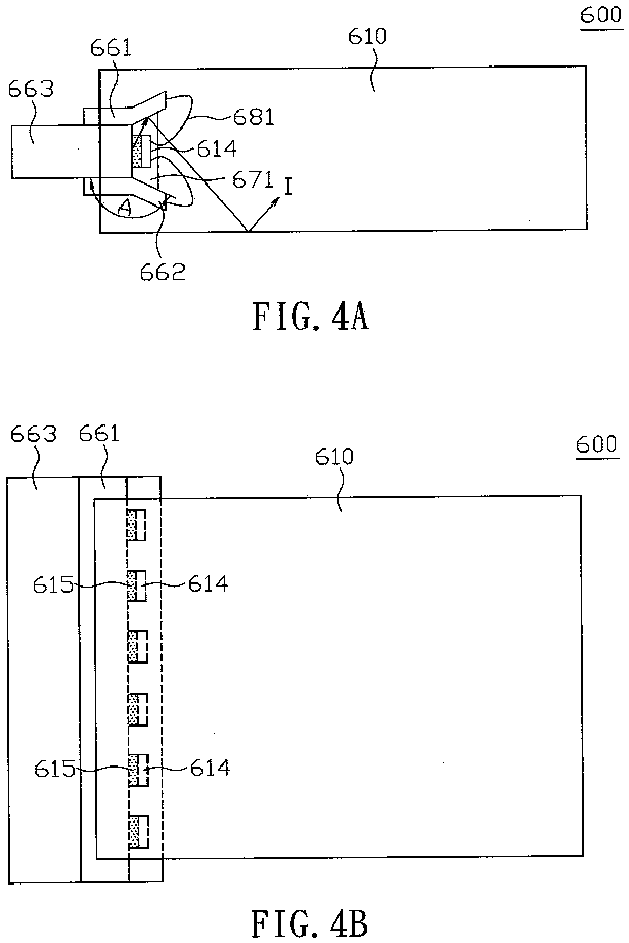

A light-emitting surface of the intermediate metal plate 663 is longitudinally narrow and disposed between the first side surface and the second side surface of the intermediate metal plate 663. Each of the first side metal plate 661 and second side metal plate 662 comprises a salient. The salients project beyond the light-emitting surface of the intermediate metal plate 663, and are bent outwardly by a predetermined angle in directions away from the first side surface and the second side surface of the intermediate metal plate 663, respectively, so that the intermediate metal plate 663, the first side metal plate 661, and the second side metal plate 662 commonly define a receiving space. More preferably, a light reflecting layer is formed on each of the side surfaces (comprising the light-emitting surface of the intermediate metal plate 663 and the inner surfaces of the salients of the first side metal plate 661 and the second side metal plate 662) defining the receiving space. In one example, as shown in FIG. 4A, the angle A of the bent portion of the second side metal plate 662 between the second side surface and the light reflecting layer is restricted to an ideal angle. The light ray I, which is outputted from a LED chip 614, is then reflected by the light reflecting layer of the first side metal plate 661, and then illuminates the side surface of a light guide plate 610, having total reflection. More preferably, the angle A is restricted to an optimum angle range, so that most of (that is, over 50% of) the light ray I, which is outputted from the LED chip 614, is then reflected by the light reflecting layer of the first side metal plate 661, and then illuminates the side surface of the light guide plate 610, having the total reflection. It is to be noted that the total reflection phenomenon relates to the material and the thickness of the light guide plate 610 and the material of the at least one package unit 671. This can be obtained by those skilled in the art by way of simulation and calculation or can be measured by way of experiment, so the specific data of the ideal angle or optimum angle range is omitted from this disclosure.

In an example, there may be more than one LED chip 614, more than one first wire 681 and more than one second wire 682. Each LED chip 614 is bonded to the light-emitting surface of the intermediate metal plate 663 by a bonding layer 615, and the LED chips 614 are arranged in one column. Each first wire 681 is coupled between a positive terminal of a LED chip 614 and the first side metal plate 661, and serves as an electroconductive path for the positive terminal of the LED chip 614. Each second wire 682 is coupled between a negative terminal of a LED chip 614 and the second side metal plate 662, and serves as an electroconductive path for the negative terminal of the LED chip 614.

The at least one package unit 671 comprises fluorescent powders and a package material, and each package unit 671 is filled into the entire receiving space of the LED light bar 620 and directly contacts a LED chip 614. In one example, LED chips 614 may be packaged in individual package units 671. In another example, the LED chips 614 may be packaged in one entire package unit 671. In one example, each package unit 671 may be filled into the entire receiving space. In another example, each package unit 671 is only filled into one portion of the receiving space to package only the LED chips 614.

FIG. 4A is a side view showing a planar light source according to an embodiment of the invention. FIG. 4B is a top view showing the planar light source of FIG. 4A. Referring to FIGS. 4A and 4B, a planar light source 600 comprises a light guide plate 610 and a LED light bar 620. The light guide plate 610 has a planar shape, the LED light bar 620 is disposed on a lateral side of the light guide plate 610, and the receiving space of the LED light bar 620 is embedded in the lateral side of the light guide plate 610. The light guide plate 610 directly contacts the at least one package unit 671, and the light guide plate 610 covers at least a portion of outer surfaces of the first side metal plate 661 and the second side metal plate 662. As shown in FIG. 4A, the at least one package unit 671 is not filled into the entire receiving space, while the light-guiding material of the light guide plate 610 is filled into the receiving space, and directly contacts the at least one package unit 671. In this example, a portion of the at least one first wire 681 and the at least one second wire 682 is packaged in the at least one package unit 671, and the other portion thereof is packaged in the light guide plate 610 or the light-guiding material.

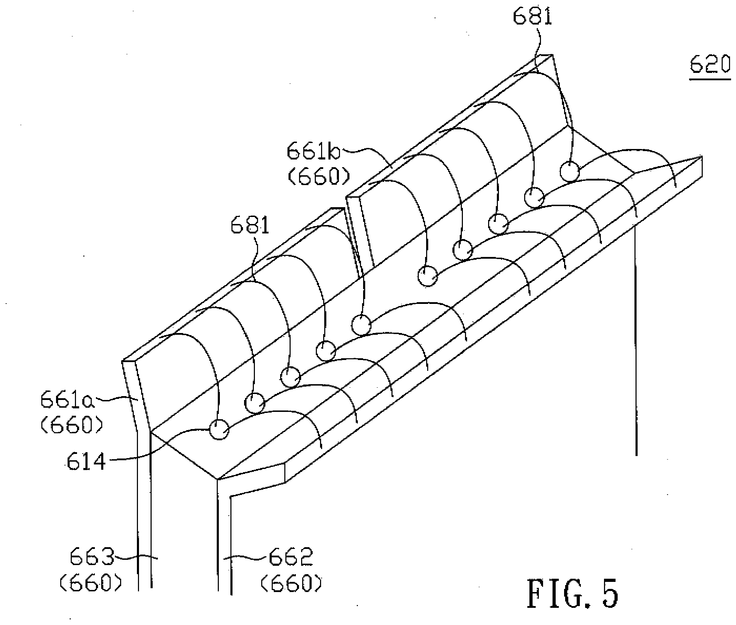

FIG. 5 is a pictorial view showing a LED light bar as used in a planar light source according to another embodiment of the invention. The LED light bar of FIG. 5 is substantially the same as the LED light bar of FIG. 3A, wherein the same references relate to the same elements and detailed descriptions thereof will be omitted. As shown in FIG. 5, the first side metal plate 661 may comprise a first, first side metal sub-plate 661a and a second, first side metal sub-plate 661b, which are separated or insulated from each other, to control different groups of LED chips 614, respectively. In addition, the second side metal plate 662 may comprise multiple separated or insulated second side metal sub-plates to connect the different groups of LED chips 614 in series or in parallel.

In summary, the LED light bar as used in the planar light source of the invention has the conciseness structure and the sufficient mechanical strength, and thus can be easily mounted in a mold (to be described later) when being integrally formed with the light guide plate, and the stable outer dimension and optical performance can be obtained after shaping.

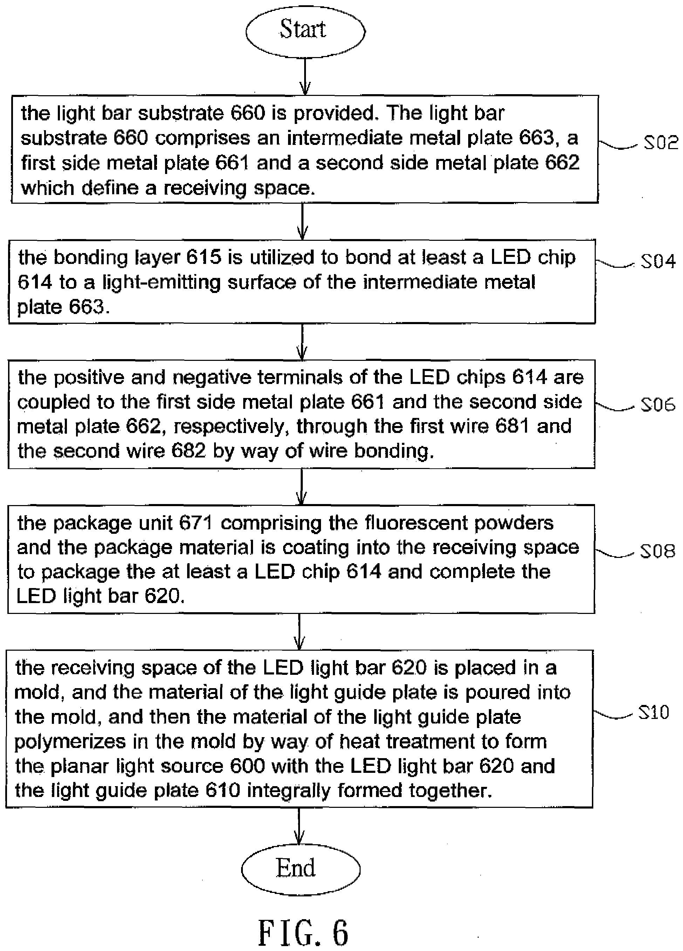

FIG. 6 is a flow chart showing a method for manufacturing a planar light source according to an embodiment of the invention.

In step S02, a light bar substrate 660 is provided. The light bar substrate 660 comprises an intermediate metal plate 663, a first side metal plate 661, and a second side metal plate 662. The first side metal plate 661 is insulatingly attached to a first side surface of the intermediate metal plate 663. The second side metal plate 662 is insulatingly attached to a second side surface of the intermediate metal plate 663. The intermediate metal plate 663, the first side metal plate 661, and the second side metal plate 662 commonly define a receiving space.

In step S04, at least one bonding layer 615 is utilized to bond at least one LED chip 614 to a light-emitting surface of the intermediate metal plate 663.

In step S06, positive and negative terminals of the at least one LED chip 614 are coupled to the first side metal plate 661 and the second side metal plate 662, respectively, through at least one first wire 681 and at least one second wire 682 by way of wire bonding.

In step S08, at least one package unit 671, comprising fluorescent powders and a package material, is coated into the receiving space to package the at least one LED chip 614 and complete the LED light bar 620.

In step S10, the receiving space of the LED light bar 620 is placed into a mold, and the material of the light guide plate is poured into the mold, and then the material of the light guide plate polymerizes in the mold by way of heat treatment to form the planar light source 600 with the LED light bar 620 and the light guide plate 610 integrally formed together.

The details of step S10 are described in the following. In a first step, the LED light bar 620 is placed on lateral sides of a top mold and a bottom mold of the mold, wherein the number of LED light bars being placed may be adjusted according to the shape of the mold. For example, a wedge-shaped light guide plate only needs one LED light bar In one example, a concave light guide plate and a flat light guide plate may have two LED light bars. In a second step, a plurality of materials are mixed into a mixture serving as the material of the light guide plate. The material comprises methyl methacrylate and a polymerization initiator. In a third step, the mixture is prepared to polymerize. This is to make the monomers of the mixture have a preliminary polymerization, and a heat treatment is also applied to make the mixture become a slurry. In a fourth step, after the top mold and the bottom mold are combined into a complete mold, the slurry is poured into the mold (mold pouring step). In a fifth step, a heat treatment is applied to make the mixture polymerize in the mold. This step needs the heat treatment to increase the polymerization speed and effect. In a sixth step, cooling and demolding are performed to form the planar light source 600 with the LED light bar 620 and the light guide plate 610 integrally formed together.

In the casting & polymerization, the fluid methyl methacrylate (MMA) slowly polymerizes into the solid acrylic (PMMA) after several hours at a working temperature lower than 110 °C and an extremely low pressure (which may be lower than the pressure used in injection, in one example). So, a LED light bar 620 mounted with a plurality of LED chips 614 may be placed between the top and bottom molds in advance, and the planar light source 600 with the LED light bar 620 and the light guide plate 610 integrally formed together can be obtained according to the process flow.

In summary, the planar light source 600 using the LED light bar 620 and the method for manufacturing the same of to the invention have the following characteristics. In the manufacturing process, the LED light bar 620 is placed in the mold in advance to obtain the planar light source 600 with the LED light bar 620 and the light guide plate 610 integrally formed together, so that most of the light rays can enter the light guide plate 610 to increase the efficiency of the planar light source significantly. In addition, the invention is to directly mount each LED chip 614 on the light bar substrate 660 without the conventionally used lead frame. So, no thermal resistance of the lead frame is present, and the heat generated by a LED chip 614 may be rapidly conducted and dissipated via the intermediate metal plate 663 of the light bar substrate 660 of the invention. Thus, the operation temperature of the LED chip 614 can be effectively lowered, and the light-emitting efficiency and lifetime can be increased.

In addition, the light bar substrate 660 of the LED light bar 620 as used in the planar light source of the invention only needs the simple electroplating, adhering and bending processes so that the rolled raw material of the light bar substrate 660 can be transformed into the light bar substrate 660. So, there is no limitation in length, and the rolled raw material may be kept continuous in the subsequent mounting of the at least one LED chip 614, bonding, wire bonding, package unit coating and the like, until the LED light bar is completed. So, compared with the prior art, the invention has the substantial progress in the light-emitting efficiency, lifetime, material cost, manufacturing cost, apparatus investment, and production efficiency.

Furthermore, the planar light source of the invention itself may serve as an illumination planar light source, as well as a backlight module of a liquid crystal display.

While the present invention has been described by way of examples and in terms of preferred embodiments, it is to be understood that the present invention is not limited thereto. To the contrary, it is intended that the present invention covers various modifications of the described examples and preferred embodiments. Thus, the scope of the invention is defined by the appended claims.

## Claims

1. A planar light source (600), comprising:
a light guide plate (610) made of a light-guiding material; and
a light-emitting diode (LED) light bar (620), comprising:
a light bar substrate (660), which comprises an intermediate metal plate (663), a first side metal plate (661), and a second side metal plate (662), and
defines a receiving space, wherein the first side metal plate (661) is insulatingly attached to a first side surface of the intermediate metal plate (663), the second side metal plate (662) is insulatingly attached to a second side surface of the intermediate metal plate (663), and the intermediate metal plate (663) comprises a light-emitting surface;
at least one bonding layer (615);
at least one LED chip (614) bonded to the light-emitting surface of the intermediate metal plate (663) by the at least one bonding layer (615);
at least one first wire (681) coupled between a positive terminal of the at least one LED chip (614) and the first side metal plate (661), and serving as an electroconductive path for the positive terminal of the at least one LED chip (614);
at least one second wire (682) coupled between a negative terminal of the at least one LED chip (614) and the second side metal plate (662), and serving as an electroconductive path for the negative terminal of the at least one LED chip (614); and
at least one package unit (671) comprising fluorescent powders and a package material for packaging the at least one LED chip (614);
wherein the LED light bar (620) is disposed on a lateral side of the light guide plate (610), at least a portion of the receiving space of the LED light bar (620) is embedded in the lateral side of the light guide plate (610), and
the light guide plate (610) directly contacts the at least one package unit (671).

2. The planar light source (600) according to claim 1, wherein the LED light bar (620) is **characterized in that**
the light-emitting surface of the intermediate metal plate (663) is longitudinally narrow, and
each of the first side metal plate (661) and the second side metal plate (662) comprises a salient, wherein the salients project beyond the light-emitting surface of the intermediate metal plate (663), and are bent outwardly by a predetermined angle in directions away from the first side surface and the second side surface of the intermediate metal plate (663), respectively, so that the light-emitting surface of the intermediate metal plate (663) and inner surfaces of the salients of the first side metal plate (661) and the second side metal plate (662) commonly define the receiving space.

3. The planar light source (600) according to claim 2, wherein the LED light bar (620) is **characterized in that** a light reflecting layer is formed on each of the light-emitting surface of the intermediate metal plate (663) and the inner surfaces of the salients of the first side metal plate (661) and the second side metal plate (662) defining the receiving space.

4. The planar light source (600) according to claim 1, wherein the LED light bar (620) is **characterized in that** the first side metal plate (661) comprises separated or insulated first side metal sub-plates for controlling different groups of LED chips (614).

5. The planar light source (600) according to claim 4, wherein the LED light bar (620) is **characterized in that** the second side metal plate (662) comprises separated or insulated second side metal sub-plates for connecting the different groups of LED chips (614) in series or in parallel.

6. The planar light source (600) according to claim 1, wherein each package unit (671) is partially filled into the receiving space, and the light-guiding material of the light guide plate (610) is filled into the receiving space and directly contacts each package unit (671).

7. A method for manufacturing a planar light source (600), the method comprising:
providing a light bar substrate (660), wherein the light bar substrate (660) defines a receiving space and comprises an intermediate metal plate (663), a first side metal plate (661), and a second side metal plate (662), wherein
the first side metal plate (661) is insulatingly attached to a first side surface of the intermediate metal plate (663), and the second side metal plate (662) is insulatingly attached to a second side surface of the intermediate metal plate (663);
utilizing at least one bonding layer (615) to bond at least one LED chip (614) to a light-emitting surface of the intermediate metal plate (663);
coupling positive and negative terminals of the at least one LED chip (614) to the first side meta! plate (661) and the second side metal plate (662) via at least one first wire (681) and at least one second wire (682) by way of wire bonding, respectively;
coating at least one package unit (671), comprising fluorescent powders and a package material, into the receiving space to package the at least one LED chip (614) and to form a LED light bar (620); and
placing the receiving space of the LED light bar (620) into a mold, and pouring a light-guiding material into the mold, and then polymerizing the light-guiding material into a light guide plate (610) in the mold by way of heat treatment to form the planar light source (600) having the LED light bar (620) and the light guide plate (610) integrally formed together.

8. The method for manufacturing a planar light source (600) according to claim 7, wherein
the light-emitting surface of the intermediate metal plate (663) is longitudinally narrow, and
each of the first side metal plate (661) and the second side metal plate (662) comprises a salient, wherein the salients project beyond the light-emitting surface of the intermediate metal plate (663), and are bent outwardly by a predetermined angle in directions away from the first side surface and the second side surface of the intermediate metal plate (663), respectively, so that the light-emitting surface of the intermediate metal plate (663) and inner surfaces of the salients of the first side metal plate (661) and the second side metal plate (662) commonly define the receiving space.

9. The method for manufacturing a planar light source (600) according to claim 8, wherein a light reflecting layer is formed on each of the light-emitting surface of the intermediate metal plate (663) and the inner surfaces of the salients of the first side metal plate (661) and the second side metal plate (662) defining the receiving space.

10. The method for manufacturing a planar light source (600) according to claim 9, wherein the first side metal plate (661) comprises separated or insulated first side metal sub-plates for controlling different groups of LED chips (614).

## Patentansprüche

1. Planare Lichtquelle (600), umfassend:
eine Lichtleiterplatte (610), die aus einem lichtleitenden Material hergestellt ist, und einen Leuchtdioden (LED) - Lichtstab (620), umfassend:
ein Lichtstab-Substrat (660), das eine dazwischenliegende Metallplatte (663), eine erste seitliche Metallplatte (661) und eine zweite seitliche Metallplatte (662) umfasst und einen Aufnahmeraum definiert, wobei die erste seitliche Metallplatte (661) isolierend an einer ersten seitlichen Oberfläche der dazwischenliegenden Metallplatte (663) angebracht ist, die zweite seitliche Metallplatte (662) isolierend an einer zweiten seitlichen Oberfläche der dazwischenliegenden Metallplatte (663) angebracht ist, und die dazwischenliegende Metallplatte (663) eine Lichtaustrittsfläche umfasst, mindestens eine Verbindungsschicht (615),
mindestens einen LED-Chip (614), der durch die mindestens eine Verbindungsschicht (615) mit der Lichtaustrittsfläche der dazwischenliegenden Metallplatte (663) verbunden ist,
mindestens einen ersten Draht (681), der zwischen einem positiven Anschluss des mindestens einen LED-Chips (614) und der ersten seitlichen Metallplatte (661) gekoppelt ist und als ein elektrisch leitender Pfad des positiven Anschlusses des mindestens einen LED-Chips (614) dient,
mindestens einen zweiten Draht (682), der zwischen einem negativen Anschluss des mindestens einen LED-Chips (64) und der zweiten seitlichen Metallplatte (662) gekoppelt ist und als ein elektrisch leitender Pfad für den negativen Anschluss des mindestens einen LED-Chips (614) dient, und
mindestens eine Verkapselungseinheit (671), umfassend fluoreszierende Pulver und ein Verkapselungsmaterial zum Verkapseln des mindestens einen LED-Chips (614),
wobei der LED-Lichtstab (620) auf einer lateralen Seite der Lichtleiterplatte (610) angeordnet ist, mindestens ein Abschnitt des Aufnahmeraums des LED-Lichtstabs (620) in der lateralen Seite der Lichtleiterplatte (610) eingebettet ist und die Lichtleiterplatte (610) die mindestens eine Verkapselungseinheit (671) direkt berührt.

2. Planare Lichtquelle (600) nach Anspruch 1, bei welcher der LED-Lichtstab (620) **dadurch gekennzeichnet ist, dass**
die Lichtaustrittsfläche der dazwischenliegenden Metallplatte (663) in Längsrichtung schmal ist und
sowohl die erste seitliche Metallplatte (661) als auch die zweite seitliche Metallplatte (662) einen Vorsprung umfasst, wobei die Vorsprünge über die Lichtaustrittsfläche der dazwischenliegenden Metallplatte (663) vorstehen und in einem vorbestimmten Winkel in Richtungen weg von der ersten seitlichen Oberfläche bzw. der zweiten seitlichen Oberfläche der dazwischenliegenden Metallplatte (663) nach außen gebogen sind, sodass die Lichtaustrittsfläche der dazwischenliegenden Metallplatte (663) und die inneren Oberflächen der Vorsprünge der ersten seitlichen Metallplatte (661) und der zweiten seitlichen Metallplatte (662) den Aufnahmeraum gemeinsam definieren.

3. Planare Lichtquelle (600) nach Anspruch 2, bei welcher der LED-Lichtstab (620) **dadurch gekennzeichnet ist, dass** eine lichtreflektierende Schicht sowohl auf der Lichtaustrittsfläche der dazwischenliegenden Metallplatte (663) als auch auf den inneren Oberflächen der Vorsprünge der ersten seitlichen Metallplatte (661) und der zweiten seitlichen Metallplatte (662) ausgebildet ist, welche den Aufnahmeraum definieren.

4. Planare Lichtquelle (600) nach Anspruch 1, bei welcher der LED-Lichtstab (620) **dadurch gekennzeichnet ist, dass** die erste seitliche Metallplatte (661) getrennte oder isolierte erste seitliche metallische Nebenplatten zum Steuern verschiedener Gruppen von LED-Chips (614) umfasst.

5. Planare Lichtquelle (600) nach Anspruch 4, bei welcher der LED-Lichtstab (620) **dadurch gekennzeichnet ist, dass** die zweite seitliche Metallplatte (662) getrennte oder isolierte zweite seitliche metallische Nebenplatten zum Verbinden der verschiedenen Gruppen von LED-Chips (614) in Reihe oder parallel umfasst.

6. Planare Lichtquelle (600) nach Anspruch 1, bei welcher jede Verkapselungseinheit (671) teilweise in den Aufnahmeraum gefüllt ist und das lichtleitende Material der Lichtleiterplatte (610) in den Aufnahmeraum gefüllt ist und jede Verkapselungseinheit (671) direkt berührt.

7. Verfahren zur Herstellung einer planaren Lichtquelle (600), wobei das Verfahren Folgendes umfasst:
Bereitstellen eines Lichtstab - Substrats (660), wobei das Lichtstab - Substrat (660) einen Aufnahmeraum definiert und eine dazwischenliegende Metallplatte (663), eine erste seitliche Metallplatte (661) und eine zweite seitliche Metallplatte (662) umfasst,
wobei die erste seitliche Metallplatte (661) isolierend an einer ersten seitlichen Oberfläche der dazwischenliegenden Metallplatte (663) angebracht ist und die zweite seitliche Metallplatte (662) isolierend an einer zweiten seitlichen Oberfläche der dazwischenliegenden Metallplatte (663) angebracht wird,
Verwenden mindestens einer Verbindungsschicht (615), um mindestens einen LED-Chip (614) mit einer Lichtaustrittsfläche der dazwischenliegenden Metallplatte (663) zu verbinden,
Koppeln positiver und negativer Anschlüsse des mindestens einen LED-Chips (614) mit der ersten seitlichen Metallplatte (661) bzw. der zweiten seitlichen Metallplatte (662) über mindestens einen Draht (681) bzw. mindestens einen zweiten Draht (682) mittels Drahtbondens,
Schichten mindestens einer Verkapselungseinheit (671), die fluoreszierende Pulver und ein Verkapselungsmaterial umfasst, in den Aufnahmeraum, um den mindestens einen LED-Chip (614) zu verkapseln und einen LED-Lichtstab (620) auszubilden, und
Platzieren des Aufnahmeraums des LED-Lichtstabs (620) in einer Form und Gießen eines lichtleitenden Materials in die Form und anschließend Polymerisieren des lichtleitenden Materials durch Wärmebehandlung in eine Lichtleiterplatte (610), um die planare Lichtquelle (600) auszubilden, wobei der LED-Lichtstab (620) und die Lichtleiterplatte (610) integral zusammen ausgebildet sind.

8. Verfahren zur Herstellung einer planaren Lichtquelle (600) nach Anspruch 7, bei welchem die Lichtaustrittsfläche der dazwischenliegenden Metallplatte (663) in Längsrichtung schmal ist, und sowohl die erste seitliche Metallplatte (661) als auch die zweite seitliche Metallplatte (662) einen Vorsprung umfasst, wobei die Vorsprünge über die Lichtaustrittsfläche der dazwischenliegenden Metallplatte (663) vorstehen und in einem vorbestimmten Winkel in Richtungen weg von der ersten seitlichen Oberfläche bzw. der zweiten seitlichen Oberfläche der dazwischenliegenden Metallplatte (663) nach außen gebogen sind, sodass die Lichtaustrittsfläche der dazwischenliegenden Metallplatte (663) und die inneren Oberflächen der Vorsprünge der ersten seitlichen Metallplatte (661) und der zweiten seitlichen Metallplatte (662) den Aufnahmeraum gemeinsam definieren.

9. Verfahren zur Herstellung einer planaren Lichtquelle (600) nach Anspruch 8, bei welchem eine lichtreflektierende Schicht sowohl auf der Lichtaustrittsfläche der dazwischenliegenden Metallplatte (663) als auch auf den inneren Oberflächen der Vorsprünge der ersten seitlichen Metallplatte (661) und der zweiten seitlichen Metallplatte (662) ausgebildet ist, welche den Aufnahmeraum definieren.

10. Verfahren zur Herstellung einer planaren Lichtquelle (600) nach Anspruch 9, bei welchem die erste seitliche Metallplatte (661) getrennte oder isolierte erste seitliche metallische Nebenplatten zum Steuern verschiedener Gruppen von LED-Chips (614) umfasst.

## Revendications

1. Source de lumière plane (600), comprenant:
une plaque de guide de lumière (610) faite d'une matière de guidage de lumière; et
une barre de lumière (620) à diode électroluminescente (LED), comprenant:
un substrat de barre de lumière (660), qui comprend une plaque intermédiaire de métal (663), une première plaque de métal latérale (661), et une seconde plaque de métal latérale (662), et définit un espace de réception, dans lequel la première plaque de métal latérale (661) est attachée de manière isolante à une première surface latérale de la plaque intermédiaire de métal (663), la seconde plaque de métal latérale (662) est attachée de manière isolante à une seconde surface latérale de la plaque intermédiaire de métal (663), et la plaque intermédiaire de métal (663) comprend une surface émettant de la lumière;
au moins une couche de liaison (615);
au moins une puce LED (614) liée à la surface émettant de la lumière de la plaque intermédiaire de métal (663) par l'au moins une couche de liaison (615); au moins un premier fil (681) couplé entre une borne positive de l'au moins une puce LED (614) et la première plaque de métal latérale (661) et servant de chemin électroconducteur pour la borne positive de l'au moins une puce LED (614);
au moins un second fil (682) couplé entre une borne négative de l'au moins une puce LED (614) et la seconde plaque de métal latérale (662) et servant de chemin électroconducteur pour la borne négative de l'au moins une puce LED (614); et
au moins une unité formant boîtier (671) comprenant des poudres fluorescentes et une matière de boîtier pour enrober l'au moins une puce LED (614);
dans lequel la barre de lumière LED (620) est disposée sur un côté latéral de la plaque de guide de lumière (610), au moins une portion de l'espace de réception de la barre de lumière LED (620) est incorporée dans le côté latéral de la plaque de guide de lumière (610), et
la plaque de guide de lumière (610) contacte directement l'au moins une unité formant boîtier (671).

2. Source de lumière plane (600) selon la revendication 1, dans laquelle la barre de lumière LED (620) est **caractérisée en ce que**
la surface émettant de la lumière de la plaque intermédiaire de métal (663) est longitudinalement étroite, et
chacune de la première plaque de métal latérale (661) et de la seconde plaque de métal latérale (662) comprend une saillie, dans laquelle les saillies dépassent au-delà de la surface émettant de la lumière de la plaque intermédiaire de métal (663) et sont pliées vers l'extérieur d'un angle prédéterminé dans des directions s'écartant respectivement de la première surface latérale et de la seconde surface latérale de la plaque intermédiaire de métal (663), de sorte que la surface émettant de la lumière de la plaque intermédiaire de métal (663) et des surfaces intérieures des saillies de la première plaque de métal latérale (661) et de la seconde plaque de métal latérale (662) définissent en commun l'espace de réception.

3. Source de lumière plane (600) selon la revendication 2, dans laquelle la barre de lumière LED (620) est **caractérisée en ce qu'**une couche réfléchissant la lumière est formée sur chacune de la surface émettant de la lumière de la plaque intermédiaire de métal (663) et des surfaces intérieures des saillies de la première plaque de métal latérale (661) et de la seconde plaque de métal latérale (662) définissant l'espace de réception.

4. Source de lumière plane (600) selon la revendication 1, dans laquelle la barre de lumière LED (620) est **caractérisée en ce que** la première plaque de métal latérale (661) comprend des premières sous-plaques de métal latérales séparées ou isolées pour commander des groupes différents de puces LED (614).

5. Source de lumière plane (600) selon la revendication 4, dans laquelle la barre de lumière LED (620) est **caractérisée en ce que** la seconde plaque de métal latérale (662) comprend des secondes sous-plaques de métal latérales séparées ou isolées pour relier les différents groupes de puces LED (614) en série ou en parallèle.

6. Source de lumière plane (600) selon la revendication 1, dans laquelle chaque unité formant boîtier (671) est partiellement remplie dans l'espace de réception et la matière de guidage de lumière de la plaque de guide de lumière (610) est remplie dans l'espace de réception et entre directement en contact avec chaque unité formant boîtier (671).

7. Procédé pour fabriquer une source de lumière plane (600), le procédé com prenant:
la fourniture d'un substrat de barre de lumière (660), dans lequel le substrat de barre de lumière (660) définit un espace de réception et comprend une plaque intermédiaire de métal (663), une première plaque de métal latérale (661), et une seconde plaque de métal latérale (662), dans lequel la première plaque de métal latérale (661) est attachée de manière isolante à une première surface latérale de la plaque intermédiaire de métal (663), et la seconde plaque de métal latérale (662) est attachée de manière isolante à une seconde surface latérale de la plaque intermédiaire de métal (663);
l'utilisation d'au moins une couche de liaison (615) pour lier au moins une puce LED (614) à une surface émettant de la lumière de la plaque intermédiaire de métal (663);
le couplage des bornes positives et négatives de l'au moins une puce LED (614) respectivement à la première plaque de métal latérale (661) et à la seconde plaque de métal latérale (662) via au moins un premier fil (681) et au moins un second fil (682) par voie de soudage des connexions;
le revêtement d'au moins une unité formant boîtier (671), comprenant des poudres fluorescentes et une matière de boîtier, dans l'espace de réception pour enrober l'au moins une puce LED (614) et pour former une barre de lumière LED (620); et
le placement de l'espace de réception de la barre de lumière LED (620) dans un moule, et le versement d'une matière de guidage de lumière dans le moule, et ensuite la polymérisation de la matière de guidage de lumière en une plaque de guide de lumière (610) dans le moule par voie de traitement thermique pour former la source de lumière plane (600) ayant la barre de lumière LED (620) et la plaque de guide de lumière (610) formées ensemble d'un seul tenant.

8. Procédé pour fabriquer une source de lumière plane (600) selon la revendication 7, dans lequel la surface émettant de la lumière de la plaque intermédiaire de métal (663) est longitudinalement étroite, et
chacune de la première plaque de métal latérale (661) et de la seconde plaque de métal latérale (662) comprend une saillie, dans lequel les saillies dépassent au-delà de la surface émettant de la lumière de la plaque intermédiaire de métal (663) et sont pliées vers l'extérieur d'un angle prédéterminé dans des directions s'écartant de la première surface latérale et de la seconde surface latérale de la plaque intermédiaire de métal (663), respectivement, de sorte que la surface émettant de la lumière de la plaque intermédiaire de métal (663) et des surfaces intérieures des saillies de la première plaque de métal latérale (661) et de la seconde plaque de métal latérale (662) définissent en commun l'espace de réception.

9. Procédé pour fabriquer une source de lumière plane (600) selon la revendication 8, dans lequel une couche réfléchissant la lumière est formée sur chacune de la surface émettant de la lumière de la plaque intermédiaire de métal (663) et des surfaces intérieures des saillies de la première plaque de métal latérale (661) et de la seconde plaque de métal latérale (662) définissant l'espace de réception.

10. Procédé pour fabriquer une source de lumière plane (600) selon la revendication 9, dans lequel la première plaque de métal latérale (661) comprend des premières sous-plaques de métal latérales séparées ou isolées pour commander des groupes différents de puces LED (614).
